# EUROPEAN PATENT APPLICATION

(11) **EP 2 816 005 A2**
(43) Date of publication of application: **24.12.2014**
(21) Application number: 14171683.7
(22) Date of filing: 09.06.2014
(51) Int. Cl.: B81B 7/00

(54) **Packaging method for MEMS devices for reducing thermal stress**

(30) Priority: 20.06.2013 US 201313922886
(71) Applicant: Honeywell International Inc., Morristown, NJ 07962-2245 (US)
(72) Inventor: Hrovat, Albert, Morristown, NJ New Jersey 07962-2245 (US)
(74) Representative: Houghton, Mark Phillip

(57) **Abstract**

In a method of packaging micro-electro-mechanical systems (MEMS) devices, an interposer board (102) is provided having a first surface (104) and an opposing second surface (106), with the interposer board including a plurality of electrical contacts (108) on the second surface. A plurality of shim layers (112) are bonded to the first surface of the interposer board, and a plurality of MEMS dies (120) are each separately bonded to a respective one of the shim layers. Each of the MEMS dies are electrically connected to the interposer board by wire bonding. A plurality of covers (130) are attached to the first surface of the interposer board over each of the MEMS dies to produce packaged MEMS devices. Each of the MEMS dies resides in a sealed cavity defined by a respective one of the covers and are substantially isolated from thermal stress.

## Description

### BACKGROUND

Micro-Electro-Mechanical Systems (MEMS) devices can include various sensors, such as gyroscopes and accelerometers, which can be implemented in inertial navigation systems. These sensors typically have microstructure sense elements that need protection from various environmental influences during fabrication and operation. For example, MEMS sensor dies that are designed to measure rotational motion are subjected to various error sources, such as outside stresses, which will degrade the rotational motion measurement. Although various packaging schemes have been developed to package sense elements in MEMS devices, these packaging schemes are typically costly and not always reliable.

### SUMMARY

In a method of packaging micro-electro-mechanical systems (MEMS) devices, an interposer board is provided having a first surface and an opposing second surface, with the interposer board including a plurality of electrical contacts on the second surface. A plurality of shim layers are bonded to the first surface of the interposer board, and a plurality of MEMS dies are each separately bonded to a respective one of the shim layers. Each of the MEMS dies are electrically connected to the interposer board by wire bonding. A plurality of covers are attached to the first surface of the interposer board over each of the MEMS dies to produce packaged MEMS devices. Each of the MEMS dies resides in a sealed cavity defined by a respective one of the covers and are substantially isolated from thermal stress.

### BRIEF DESCRIPTION OF THE DRAWINGS

Understanding that the drawings depict only exemplary embodiments and are not therefore to be considered limiting in scope, the exemplary embodiments will be described with additional specificity and detail through the use of the accompanying drawings, in which:
Figure 1A is a cross-sectional side view of a packaged MEMS device according to one embodiment;
Figure 1B is an exploded perspective view of the packaged MEMS device of Figure 1A without a cover;
Figure 2 is a cross-sectional view of a MEMS sensor assembly according to one embodiment; and
Figures 3A and 3B are perspective views of opposite sides of a MEMS sensor assembly that can be employed in an inertial measurement unit according to one embodiment.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

A packaging technique for Micro-Electro-Mechanical Systems (MEMS) devices is described herein. The present approach can employ standard integrated circuit (IC) packaging techniques combined with an isolation structure that minimizes unmodelable errors due to environmental temperature effects. The present approach can be used with standard IC high volume production techniques, while having a lower cost because of the use of readily available materials.

MEMS devices packaged according to the present method can be implemented in various sensor systems, such as an inertial measurement unit (IMU), for example. The packaging technique addresses the demanding size, cost, and performance issues of IMU products that employ MEMS sensors.

In general, the present method includes producing an array of interposer bases, which can be fabricated in groups of 100 or more, for example, to form conversion boards. One or more isolation shims are then bonded to each of the interposer bases, with one shim bonded per die attach point. A MEMS die is then bonded to each of the shims. Wire bonding can be used to electrically connect the MEMS die to the interposer bases. A lid or cover is then attached to the interposer base over each MEMS die to protect the MEMs die from damage during subsequent handling. The packaged MEMS die are then cut into individual parts using a standard singulation process.

The present approach is described in further detail hereafter with respect to the drawings.

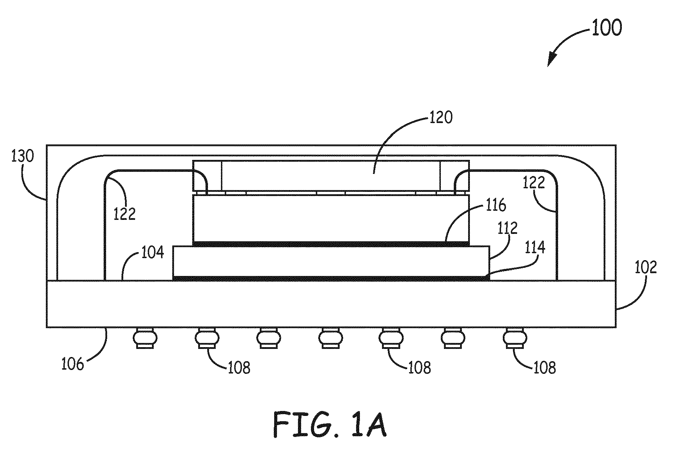

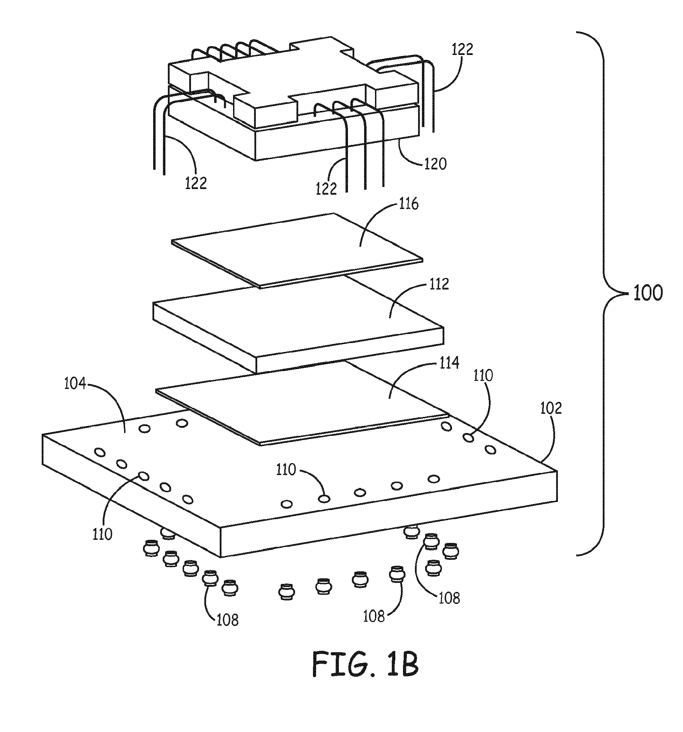

Figures 1A and 1B illustrate a packaged MEMS device 100 according to one embodiment. The MEMS device 100 includes an interposer layer 102 with a first surface 104 and an opposing second surface 106. A plurality of electrical contacts 108 such as solder balls are attached to second surface 106. The interposer layer 102 includes a plurality of internal interconnects between contacts 108, and corresponding bond pads 110 located on first surface 104 (Figure 1B). In one embodiment, interposer layer 102 can be a conversion board or printed circuit board (PCB) composed of various materials, such as fiberglass or polymide laminates.

A shim layer 112 is attached to first surface 104 of interposer layer 102. The shim layer 112 is bonded to first surface 104 with a first epoxy layer 114. A MEMS die 120 is bonded to shim layer 112 with a second epoxy layer 116. The shim layer 112, the first epoxy layer 114, and the second epoxy layer 116, combine to substantially isolate MEMS die 120 from thermal stress caused by interposer layer 102.

In an exemplary embodiment, the first and second epoxy layers 114, 116 have a thickness of about 30-50 microns, and a Young's modulus of at least about 1,000,000 psi when cured.

In one embodiment, shim layer 112 is composed of a material having a coefficient of thermal expansion that is close to the coefficient of thermal expansion of the material used to form MEMS 120 die. For example, if the MEMS die comprises a material with a coefficient of thermal expansion having a first value, the shim layer can comprise a material with a coefficient of thermal expansion having a second value that is at least about 90 % of the first value. Suitable materials that can be used in forming the shim layer include silicon, glass, alumina, or sapphire, for example.

The MEMS die 120 can be electrically connected to interposer layer 102 through a plurality of bond wires 122 that are attached to bond pads 110 in a wire bonding process. The MEMS die 120 can include a gyroscope, an accelerometer, or other MEMS sensor device.

A shown in Figure 1A, a cover is 130 is sealingly attached to upper surface 114 over MEMS die 120. The cover 130 provides a water tight seal to protect MEMS die 120 from water during final wash after packaging is complete. The cover 130 also facilitates handling of MEMS device 100 during implementation such as in an inertial sensor system, and provides protection from the environment during operation.

While Figure 1B illustrates a single MEMS device, this same configuration can be used in forming multiple MEMS devices on an interposer board. For example, a plurality of shim layers can be bonded to the interposer board, and a plurality of MEMS dies are then each separately bonded to a respective one of the shim layers. A plurality of covers are then attached to the interposer board over each of the MEMS dies to produce multiple packaged MEMS devices, which can be separated from each other into respective individual MEMS devices.

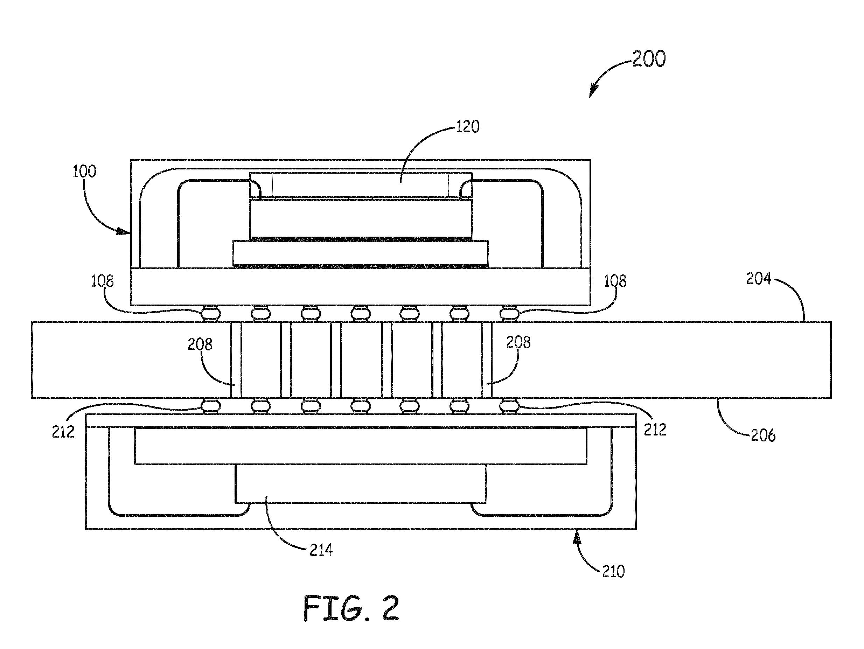

Figure 2 illustrates a partial cross-sectional view of a MEMS sensor assembly 200, which implements a packaged MEMS device such as MEMS device 100 (Figure 1A). The MEMS sensor assembly includes a circuit card 202 having a first surface 204 and an opposing second surface 206. A plurality of vias 208 extend between first surface 204 and second surface 206.

The MEMS device 100 is mounted on first surface 204 of circuit card 202. The contacts 108 such as solder balls are attached to bond pads on first surface 204 such that MEMS device 100 is electrically coupled to circuit card 210.

An application specific integrated circuit (ASIC) 210 is mounted on second surface 206 of circuit card 202 directly opposite from MEMS device 100. The ASIC 210 has a plurality of electrical contacts 212 such as solder balls that are attached to bond pads on second surface 206 such that ASIC 210 is electrically coupled to circuit card 210.

The MEMS device 100 is in electrical communication with ASIC 210 through vias 208. The ASIC 210 generally includes an IC die 214 that includes operating circuitry for sensing, signal conditioning, and control of MEMS die 120.

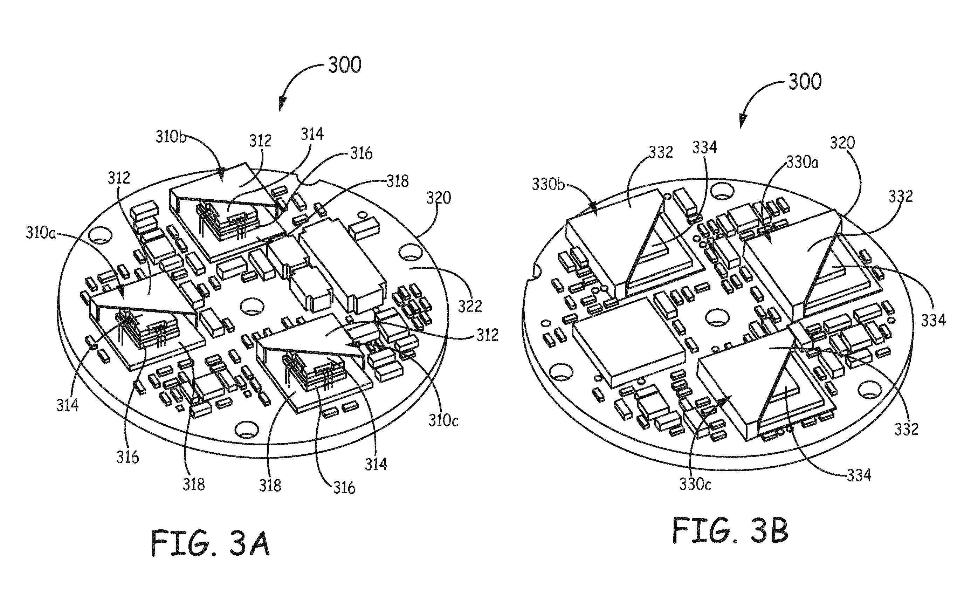

Figures 3A and 3B are perspective views of opposite sides of a MEMS sensor assembly 300 that can be employed in an inertial measurement unit according to one embodiment. As shown in Figure 3A, MEMS sensor assembly 300 includes three packaged MEMS inertial sensor devices 310a, 310b, and 310c, such as MEMS gyroscopes or MEMS accelerometers, which are mounted to a circuit card 320 on a first surface side 322 thereof.

The MEMS inertial sensor devices 310a, 310b, and 310c include similar components and are packaged in a similar fashion as described above for MEMS device 100. A cover 312 is shown partially cut away over each of the MEMS inertial sensor devices 310a, 310b, and 310c, to reveal the underlying internal components, including a MEMS die 314, a shim layer 316, and an interposer layer 318.

Figure 3B depicts the opposite side of MEMS sensor assembly 300, in which three ASICs 330a, 330b, and 330c are mounted on a second surface 332 of circuit card 320 directly opposite from corresponding MEMS inertial sensor devices 310a, 310b, and 310c shown in Figure 3A. Each of MEMS inertial sensor devices 310a, 310b, and 310c are in electrical communication with a corresponding ASIC 330a, 330b, and 330c through vias in circuit card 320.

The ASICs 330a, 330b, and 330c include similar components as described above for ASIC 210 (Figure 2). A cover 332 is shown partially cut away over each of the ASICs 330a, 330b, and 330c to reveal the underlying internal components, including an IC die 334 that includes operating circuitry for the corresponding MEMS inertial sensor device.

### Example Embodiments

Example 1 includes a method of packaging micro-electro-mechanical systems (MEMS) devices, comprising: providing an interposer board having a first surface and an opposing second surface, the interposer board including a plurality of electrical contacts on the second surface; bonding a plurality of shim layers to the first surface of the interposer board; bonding a plurality of MEMS dies each separately to a respective one of the shim layers; electrically connecting each of the MEMS dies to the interposer board by wire bonding; and attaching a plurality of covers to the first surface of the interposer board over each of the MEMS dies to produce packaged MEMS devices. Each of the MEMS dies resides in a sealed cavity defined by a respective one of the covers and are substantially isolated from thermal stress.

Example 2 includes the method of Example 1, wherein the MEMS dies are formed of a material with a coefficient of thermal expansion having a first value, and the shim layer is formed of a material with a coefficient of thermal expansion having a second value that is at least about 90 % of the first value.

Example 3 includes the method of any of Examples 1-2, wherein the shim layers are formed with a material comprising silicon, glass, alumina, or sapphire.

Example 4 includes the method of any of Examples 1-3, wherein the MEMS dies comprise inertial sensor dies.

Example 5 includes the method of any of Examples 1-4, wherein the MEMS dies comprise gyroscopes or accelerometers.

Example 6 includes the method of any of Examples 1-5, wherein the shim layers and MEMS dies are each bonded with an epoxy material having a Young's modulus of at least about 1,000,000 psi when cured.

Example 7 includes the method of any of Examples 1-6, and further comprising: separating the packaged MEMS devices from each other into respective individual MEMS devices; and connecting one or more of the individual MEMS devices to a circuit card.

Example 8 includes a packaged micro-electro-mechanical systems (MEMS) device, comprising: an interposer layer having a first surface and an opposing second surface; a first epoxy layer on the first surface of the interposer layer; a shim layer attached to the first surface of the interposer layer with the first epoxy layer; a second epoxy layer on the shim layer; and a MEMS die attached to the shim layer with the second epoxy layer, the MEMS die electrically connected to the interposer layer. The first epoxy layer, the shim layer, and the second epoxy layer substantially isolate the MEMS die from thermal stress.

Example 9 includes the packaged MEMS device of Example 8, wherein the MEMS die comprises a material with a coefficient of thermal expansion having a first value, and the shim layer comprises a material with a coefficient of thermal expansion having a second value that is at least about 90 % of the first value.

Example 10 includes the packaged MEMS device of any of Examples 8-9, wherein the shim layer comprises silicon, glass, alumina, or sapphire.

Example 11 includes the packaged MEMS device of any of Examples 8-10, wherein the first and second epoxy layers have a Young's modulus of at least about 1,000,000 psi.

Example 12 includes the packaged MEMS device of any of Examples 8-11, wherein the MEMS die comprises an inertial sensor die.

Example 13 includes the packaged MEMS device of any of Examples 8-12, wherein the MEMS die comprises a gyroscope or an accelerometer.

Example 14 includes the packaged MEMS device of any of Examples 8-13, and further comprising a cover attached to the first surface of the interposer layer over the MEMS die such that the MEMS die resides in a sealed cavity defined by the cover.

Example 15 includes the packaged MEMS device of any of Examples 8-14, wherein the interposer layer comprises a conversion board or printed circuit board.

Example 16 includes the packaged MEMS device of any of Examples 8-15, and further comprising a plurality of electrical contacts on the second surface of the interposer layer.

Example 17 includes the packaged MEMS device of Example 16, wherein the electrical contacts are electrically connected to a circuit card.

Example 18 includes a micro-electro-mechanical systems (MEMS) sensor assembly, comprising: a circuit card having a first surface and an opposing second surface; a plurality of vias extending between the first surface and the second surface of the circuit card; at least one MEMS device mounted on and in electrical contact with the first surface of the circuit card. The MEMS device comprises a conversion board having a first surface and an opposing second surface; a shim layer attached to the first surface of the conversion board; a MEMS die attached to the shim layer and electrically connected to the conversion board; and a cover attached to the first surface of the conversion board over the MEMS die. At least one application specific integrated circuit (ASIC) is mounted on and in electrical contact with the second surface of the circuit card opposite from the MEMS device. The ASIC is in electrical communication with the MEMS device through the vias.

Example 19 includes the MEMS sensor assembly of Example 18, wherein the MEMS die comprises a gyroscope or an accelerometer.

Example 20 includes the MEMS sensor assembly of Examples 19, wherein the at least one MEMS device and ASIC are implemented as part of an inertial measurement unit.

The present invention may be embodied in other forms without departing from its essential characteristics. The described embodiments are to be considered in all respects only as illustrative and not restrictive. Therefore, it is intended that this invention be limited only by the claims and the equivalents thereof.

## Claims

1. A method of packaging micro-electro-mechanical systems (MEMS) devices, the method comprising:
providing an interposer board having a first surface and an opposing second surface, the interposer board including a plurality of electrical contacts on the second surface;
bonding a plurality of shim layers to the first surface of the interposer board;
bonding a plurality of MEMS dies each separately to a respective one of the shim layers;
electrically connecting each of the MEMS dies to the interposer board by wire bonding; and
attaching a plurality of covers to the first surface of the interposer board over each of the MEMS dies to produce packaged MEMS devices, wherein each of the MEMS dies resides in a sealed cavity defined by a respective one of the covers and are substantially isolated from thermal stress.

2. The method of claim 1, wherein the MEMS dies are formed of a material with a coefficient of thermal expansion having a first value, and the shim layer is formed of a material with a coefficient of thermal expansion having a second value that is at least about 90 % of the first value.

3. The method of claim 1, wherein the shim layers are formed with a material comprising silicon, glass, alumina, or sapphire.

4. The method of claim 1, wherein the MEMS dies comprise inertial sensor dies.

5. The method of claim 1, wherein the MEMS dies comprise gyroscopes or accelerometers.

6. The method of claim 1, wherein the shim layers and MEMS dies are each bonded with an epoxy material having a Young's modulus of at least about 1,000,000 psi when cured.

7. The method of claim 1, further comprising:
separating the packaged MEMS devices from each other into respective individual MEMS devices; and
connecting one or more of the individual MEMS devices to a circuit card.

8. A packaged micro-electro-mechanical systems (MEMS) device, comprising:
an interposer layer having a first surface and an opposing second surface;
a first epoxy layer on the first surface of the interposer layer;
a shim layer attached to the first surface of the interposer layer with the first epoxy layer;
a second epoxy layer on the shim layer; and
a MEMS die attached to the shim layer with the second epoxy layer, the MEMS die electrically connected to the interposer layer;
wherein the first epoxy layer, the shim layer, and the second epoxy layer substantially isolate the MEMS die from thermal stress.

9. The packaged MEMS device of claim 8, wherein the first and second epoxy layers have a Young's modulus of at least about 1,000,000 psi.

10. A micro-electro-mechanical systems (MEMS) sensor assembly, comprising:
a circuit card having a first surface and an opposing second surface;
a plurality of vias extending between the first surface and the second surface of the circuit card;
at least one MEMS device mounted on and in electrical contact with the first surface of the circuit card, the MEMS device comprising:
a conversion board having a first surface and an opposing second surface;
a shim layer attached to the first surface of the conversion board;
a MEMS die attached to the shim layer and electrically connected to the conversion board; and
a cover attached to the first surface of the conversion board over the MEMS die; and
at least one application specific integrated circuit (ASIC) mounted on and in electrical contact with the second surface of the circuit card opposite from the MEMS device, the ASIC in electrical communication with the MEMS device through the vias.
